**Europäisches Patentamt**

**European Patent Office**

**Office européen des brevets**

(11) Veröffentlichungsnummer: **0 232 763**
**B1**

(12) **EUROPÄISCHE PATENTSCHRIFT**

(45) Veröffentlichungstag der Patentschrift:
**11.04.90**

(21) Anmeldenummer: **87100851.2**

(22) Anmeldetag: **22.01.87**

(51) Int. Cl.⁴: **G01R 21/00**

(54) **Elektronischer Elektrizitätszähler.**

(30) Priorität: **04.02.86 DE 3603340**

(43) Veröffentlichungstag der Anmeldung:
**19.08.87 Patentblatt 87/34**

(45) Bekanntmachung des Hinweises auf die Patenterteilung:
**11.04.90 Patentblatt 90/15**

(84) Benannte Vertragsstaaten:
**AT BE CH DE FR GB IT LI SE**

(56) Entgegenhaltungen:
**EP-A- 0 104 988**
**GB-A- 2 076 975**

**TECHNISCHES MESSEN ATM, Band 45, Nr. 11, 1978, Seiten 407-411; G. STEINMÜLLER: "Ein genauer elektronischer Elektrizitätzähler"**

(73) Patentinhaber: **Siemens Aktiengesellschaft, Wittelsbacherplatz 2, D-8000 München 2(DE)**

(72) Erfinder: **Förder, Walter Dipl.-Phys., Gewendeweg 74, D-8510 Fürth(DE)**

**Beschreibung**

Die Erfindung betrifft einen elektronischen Elektrizitätszähler mit einem nach dem Time-Division-Verfahren arbeitenden Multiplizierer für eine erste und eine zweite Eingangsgröße, wobei die erste Eingangsgröße einem einen Bestandteil des Multiplizierers darstellenden Modulator zugeführt ist, und mit einem dem Multiplizierer nachgeschalteten Quantisierer, der nach dem Ladungskompensationsverfahren arbeitet und mit einem Integrator und einem nachgeschalteten ersten Komparator ausgeführt ist.

Ein derartiger elektronischer Elektrizitätszähler ist aus der Zeitschrift "Technisches Messen atm" 1978, Heft 11, Seite 407 bis 411 bekannt. Dabei enthält der Multiplizierer einen Modulator, der eine Impulsfolge bildet, deren Puls-Pausen-Verhältnis einer ersten Eingangsgröße proportional ist. Dazu wird mit der Summe oder der Differenz aus einem konstanten Referenzstrom und einem dem Verbraucherstrom proportionalen Meßstrom ein Kondensator aufgeladen bzw. entladen. Ein nachgeschalteter Grenzwertschalter spricht an, wenn die Kondensatorspannung einen oberen bzw. unteren Grenzwert erreicht hat. Der Grenzwertschalter steuert die Auf- bzw. Entladung des Kondensators. In der Praxis wird anstelle des Kondensators stets ein Integrator mit einem Operationsverstärker verwendet, der zusätzlich zum Kondensator eine Widerstandsbeschaltung aufweist.

Der Quantisierer ist bei einer in der obengenannten Literaturstelle dargestellten Ausführungsform nach dem sogenannten Ladungskompensationsverfahren aufgebaut, bei dem ein von der Spannung abgeleiteter Meßstrom einen Kondensator auflädt, bis die obere Triggerspannung einer Grenzwertstufe erreicht ist. Die Grenzwertstufe stößt dabei eine quarzstabilisierte Zeitstufe an, die für eine konstante Zeit einen Referenzstrom auf den Kondensator schaltet. Der Kondensator wird dabei um einen gewissen Betrag entladen. Anschließend lädt der von der Spannung abgeleitete Meßstrom den Kondensator wieder bis zur Triggerspannung hoch. Die erzielte Ausgangsfrequenz ist damit dem Ausgangsstrom des Multiplizierers proportional. Auch für den Quantisierer wird in der Praxis ein Operationsverstärker mit Widerstands- und Kondensatorbeschaltung eingesetzt.

Die bei herkömmlichen elektronischen Elektrizitätszählern erforderlichen Widerstände sind bei integrierten Schaltungen in der erforderlichen Genauigkeit und Temperaturunabhängigkeit nur schwer herzustellen.

Aus der EP-A 0 104 988 ist ein nach dem Delta-Sigma-Verfahren arbeitender Kodierer bekannt, bei dem Widerstände durch von einem Taktsignal geschaltete Kapazitäten ersetzt sind.

Aufgabe der Erfindung ist es daher, einen elektronischen Elektrizitätszähler der eingangs genannten Art so auszugestalten, daß möglichst wenig oder gar keine Widerstände verwendet werden.

Diese Aufgabe wird erfindungsgemäß gelöst durch die kennzeichnenden Merkmale des Patentanspruchs 1.

Dabei sind für den Multiplizierer und den Quantisierer keinerlei Widerstände erforderlich, sondern zusätzlich zum Operationsverstärker lediglich Kondensatoren und Schalter. Kondensatoren lassen sich jedoch in integrierter Technik wesentlich temperaturstabiler herstellen als Widerstände. Außerdem ist für die Invertierung der ersten Eingangsgröße kein Inverter erforderlich, so daß ein Operationsverstärker eingespart werden kann.

Bei einer Ausführung des elektronischen Elektrizitätszählers gemäß Patentanspruch 2 wird auch der Modulator völlig ohne Widerstände, lediglich unter Verwendung von Kondensatoren, Schaltern und Operationsverstärkern aufgebaut.

Die Abfühlung der zweiten Eingangsgröße über eine Spannungsfolgerschaltung gemäß Patentanspruch 3 erlaubt ein hochohmiges Abtasten der zweiten Eingangsgröße. Außerdem verzögert diese Schaltung die zweite Eingangsgröße um einen Takt und gleicht damit die Verzögerung der ersten Eingangsgröße um einen Takt im Modulator wieder aus.

Eine Verstärkung der zweiten Eingangsgröße kann einfach durch eine Dimensionierung der Kondensatoren gemäß Anspruch 4 erzielt werden. Dabei ist die Verstärkung gleich dem Verhältnis der Kapazitäten der beiden Kondensatoren.

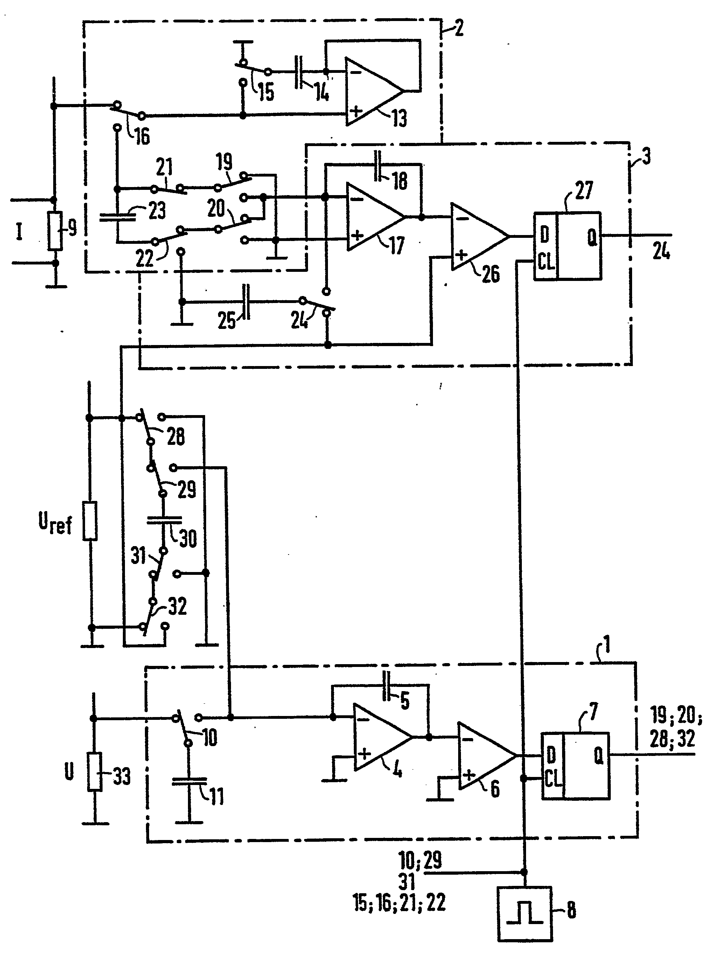

Ein Ausführungsbeispiel der Erfindung wird nachfolgend anhand der Figur näher erläutert.

Der Modulator des elektronischen Elektrizitätszählers ist in der Figur gestrichelt umrandet und mit 1 bezeichnet. Dem Modulator 1 wird die an einem Widerstand 33 abfallende, der Netzspannung proportionale Spannung U zugeführt. Ein Kondensator 11 ist über einen Umschalter 10 wahlweise mit der Spannung U oder mit dem invertierenden Eingang eines Operationsverstärkers 4 verbunden. Ferner kann dem invertierenden Eingang des Operationsverstärkers 4 über eine noch zu erläuternde Schaltung eine Referenzladung zugeführt werden. Der nichtinvertierende Eingang des Operationsverstärkers 4 ist mit Bezugspotential verbunden. Der Ausgang des Operationsverstärkers 4 ist mit einem Kondensator 5 auf seinen invertierenden Eingang zurückgekoppelt und mit einem Eingang des Komparators 6 verbunden, dessen Vergleichseingang auf Bezugspotential liegt. Der Ausgang des Komparators 6 ist mit dem D-Eingang eines D-Flip-Flops 7 verbunden. Der Takteingang des D-Flip-Flops 7 wird von einem Taktgeber 8 angesteuert. Der Ausgang des D-Flip-Flops 7 stellt zugleich den Ausgang des Modulators 1 dar und steuert eine Reihe noch zu erläuternder Schalter 19, 20, 28 und 32.

Die Schaltung zur Erzeugung einer Referenzladung enthält einen Kondensator 30, dessen einer Anschluß über einen Umschalter 29 wahlweise mit einem weiteren Umschalter 28 oder mit dem invertierenden Eingang des Operationsverstärkers 4 verbindbar ist und dessen zweiter Anschluß über einen Umschalter 31 wahlweise mit einem Umschalter 32 oder mit Bezugspotential verbindbar ist. Der Umschalter 28 verbindet den ersten Anschluß des Kondensators 30 wahlweise mit einer Referenzspannung $U_{Ref}$ oder mit Bezugspotential und der Umschalter 32 verbindet den zweiten Anschluß des Kondensators 30 mit dem Bezugspotential oder mit der Referenzspannung $U_{Ref}$. Damit ist der Kondensator 30 je nach Stellung der gleichzeitig betätigten Umschalter 28 und 32 wahlweise in beiden Polungen mit der Referenzspannung $U_{Ref}$ verbindbar.Die Umschalter 10, 22, 29 und 31 werden vom Taktgeber 8, die Umschalter 28 und 32 vom Ausgang des D-Flip-Flops 7 angesteuert.

Zur Erläuterung der Schaltung sei zunächst angenommen, daß die Ausgangssignale des Taktgebers 8 und des D-Flip-Flops 7 Null sind. Damit stehen alle Schalter in der eingezeichneten Stellung. Der Kondensator 11 wird auf eine der Spannung U proportionale Spannung und damit proportionale Ladung aufgeladen und der Kondensator 30 wird auf die Referenzspannung $U_{Ref}$ und damit mit einer Referenzladung aufgeladen.

Wenn nun das Ausgangssignal des Taktgebers 8 auf "1" wechselt, so werden die Umschalter 10, 29 und 31 umgeschaltet. Damit sind nun am invertierenden Eingang des Operationsverstärkers 4 die beiden Kondensatoren 11 und 30 angeschlossen, wobei der Kondensator 30 eine positive Referenzladung und der Kondensator 11 eine der Spannung U proportionale Ladung trägt. Die auf den Kondensatoren 11 und 30 befindliche Ladung wird nunmehr in den Integrationskondensator 5 übertragen.

In der nächsten Taktphase wird der Kondensator 11 wieder auf eine der Spannung U proportionale Ladung und der Kondensator 30 auf eine Referenzladung aufgeladen. Dieser Zyklus wird solange periodisch fortgesetzt, bis der Komparator 6 anspricht und mit dem nächsten Takt des Taktgebers 8 das Flip-Flop 7 sein Ausgangssignal ändert. Damit wird der Kondensator 30 umgepolt und wird somit auf eine negative Referenzladung aufgeladen.

Während bisher in einer Aufladezeit $T_1$ die Summe der Referenzladung und der spannungsabhängigen Ladung integriert wurde, wird nunmehr während einer Entladezeit $T_2$ die Differenz der spannungsabhängigen Ladung und der Referenzladung integriert. Da das Ausgangssignal des Integrators 4 immer wieder auf dasselbe Potential zurückkehrt, muß im Mittel die Ladung während der Aufladezeit $T_1$ gleich der Ladung während der Entladezeit $T_2$ sein. Da die entsprechenden Ladungen der Häufigkeit der Ladevorgänge und damit der Zeit der entsprechenden Ladevorgänge proportional sind und die Ladungen wegen der konstanten Kapazitäten wiederum den Spannungen proportional sind, gilt also:

$$\frac{n_1 T_1 - n_2 T_2}{n_1 T_1 + n_2 T_2} = \frac{U}{U_{ref}}$$

wobei:
$n_1$ = Anzahl der positiven Takte
$n_2$ = Anzahl der negativen Takte
Damit ist also das Einschaltverhältnis am Ausgang des Flip-Flops 7 dem Verhältnis $U/U_{Ref}$ proportional. Der Modulator 1 arbeitet also nach dem Delta-Sigma-Verfahren, wie es auch in der EP-A2-00 84 353 beschrieben ist.

Im folgenden soll nun der ebenfalls gestrichelt umrahmte zweite Teil 2 des Multiplizierers erläutert werden.

Der Strom I als zweite Eingangsgröße erzeugt an einem Widerstand 9 eine proportionale Spannung $U_I$. Ein Operationsverstärker 13 ist als Spannungsfolger geschaltet, d.h. sein Ausgang ist direkt auf den invertierenden Eingang zurückgekoppelt. Der nichtinvertierende Eingang des Operationsverstärkers 13 ist über einen Umschalter 16 wahlweise mit dieser Spannung $U_I$ oder mit einem ersten Anschluß eines Kondensators 23 verbunden. Der invertierende Eingang des Operationsverstärkers 13 ist über einen Kondensator 14 und einen Umschalter 15 wahlweise mit Bezugspotential oder mit dem nichtinvertierenden Eingang verbindbar.

Der erste Anschluß des Kondensators 23 ist über einen Schalter 21 und einen Umschalter 19 wahlweise mit dem invertierenden Eingang eines Operationsverstärkers 17 oder mit Bezugspotential verbindbar. Der zweite Anschluß des Kondensators 23 ist über einen Umschalter 22 wahlweise mit Bezugspotential oder mit einem Anschluß eines weiteren Umschalters 20 verbindbar. Der Umschalter 20 verbindet diesen Anschluß entweder mit dem invertierenden Eingang des Operationsverstärkers 17 oder mit Bezugspotential. Der Ausgang des Operationsverstärkers 17 ist über einen Kondensator 18 mit seinem invertierenden Eingang und direkt mit dem invertierenden Eingang eines Komparators 26 verbunden. Der nichtinvertierende Eingang des Komparators 26 ist an die Referenzspannung $U_{Ref}$ angeschlossen. Der Ausgang des Komparators 26 ist mit dem Eingang eines D-Flip-Flops 27 verbunden, dessen Takteingang vom Taktgeber 8 angesteuert wird. Der Ausgang des D-Flip-Flops 27 steuert einen Umschalter 24. Dieser legt einen Anschluß eines Kondensators 25 an die Referenzspannung, wenn das Ausgangssignal des D-Flip-Flops 27 "0" ist oder an den invertierenden Eingang des Operationsverstärkers 17, wenn dieses Ausgangssignal "1" ist. Der zweite Anschluß des Kondensators 25 liegt fest an Bezugspotential.

Zur Erläuterung der Schaltung wird zunächst wieder angenommen, daß die Ausgangssignale des Taktgebers 8 und des D-Flip-Flops 27 "0" sind und somit alle Schalter in der eingezeichneten Stellung stehen. Damit wird der Kondensator 14 über den Umschalter 16, den Operationsverstärker 13 und den Umschalter 15 auf eine dem Strom I proportionale Ladung aufgeladen. Der Kondensator 23 ist noch von der vorhergehenden Taktphase auf eine dem Strom I proportionale Ladung aufgeladen und gibt diese über die Schalter 19, 21, 22, 20 und den Operationsverstärker 17 an den Kondensator 18 ab. Dabei hängt es von der Stellung der Umschalter 19 und 20, d.h. vom Ausgangssignal des Modulators 1 ab, ob der Kondensator 18 die Ladung in positiver oder in negativer Richtung integriert. Im zeitlichen Mittelwert ist daher die integrierte Ladung dem Produkt aus dem Strom I und der Ladung U proportional.

Bei der nächsten Taktphase wechseln die Stellungen der Umschalter 15, 16 und 22 und der Schalter 21. Damit wird die Ladung des Kondensators 14 auf den Kondensator 23 übertragen, so daß diese wieder eine dem Strom I proportionale Ladung aufweist. Dieser Vorgang wird periodisch wiederholt.

Wenn nach einer Anzahl von Taktphasen die Ausgangsspannung des Operationsverstärkers 17 die Ansprechschwelle des Komparators 26 erreicht und mit der nächsten Taktphase das Ausgangssignal des D-Flip-Flops 27 wechselt, schaltet der Umschalter 24 den vorher auf die Referenzspannung $U_{Ref}$ aufgeladenen Kondensator 25 an den Operationsverstärker 17. Der Kondensator 25 ist so bemessen, daß seine Ladung stets größer ist als die vom Kondensator 23 aufgebrachte Ladung, so daß der Kondensator 18 stets um einen gewissen Betrag entladen wird.. Anschließend wird der Kondensator 18 über den Kondensator 23 periodisch wieder aufgeladen. Dabei muß die während einer Periodendauer zugeführte Ladungsmenge gleich der abgeführten Ladungsmenge $Q_r$ sein. Die zugeführte Ladungsmenge ist dem Strom I und der Differenz der positiven und negativen Taktlängen

$$n_1 T_1 - n_2 T_2 = T$$

proportional. Daraus folgt:

$$T \cdot I = Q_r$$

und somit für die Ausgangsfrequenz $f_A$ des Flip-Flops 27 im zeitlichen Mittel:

$$f_A = \frac{I}{Q_r}$$

Die Ausgangsfrequenz des Flip-Flops 27 ist damit direkt proportional der Leistung. Wenn man diese Ausgangsimpulse aufsummiert, so erhält man direkt ein Maß für die elektrische Energie.

Damit wurde dargelegt, daß mit der erfindungsgemäßen Lösung die elektrische Leistung ohne Widerstände in der Meßschaltung erfaßt werden kann. Die dargestellte Schaltung läßt sich somit einfach und ohne Probleme mit der Temperaturstabilität als integrierte Schaltung realisieren.

**Patentansprüche**

1. Elektronischer Elektrizitätszähler mit einem nach dem Time-Division-Verfahren arbeitenden Multiplizierer (1, 2) für eine erste und eine zweite Eingangsgröße (U, I), wobei die erste Eingangsgröße (U) einem einen Bestandteil des Multiplizierers (1, 2) darstellenden Modulator (1) zugeführt ist, und mit einem dem Multiplizierer (1, 2) nachgeschalteten Quantisierer (3), der nach dem Ladungskompensationsverfahren arbeitet und mit einem Integrator (17, 18) und einem nachgeschalteten ersten Komparator (26) ausgeführt ist, dadurch gekennzeichnet, daß der Multiplizierer (1, 2) und der Quantisierer (3) folgende Merkmale aufweisen:

a) Während jeder ersten Taktphase eines Taktgebers (8) wird ein erster Kondensator (23) an den Eingang des Integrators (17, 18) geschaltet.

b) Während jeder zweiten Taktphase des Taktgebers (8) wird der erste Kondensator (23) mit einer der zweiten Eingangsgröße (I) proportionalen Ladung aufgeladen.

c) Die Polarität, mit der der erste Kondensator (23) an den Eingang des Integrators (17, 18) gelegt wird, wird vom Ausgangssignal des nach dem Delta-Sigma-Verfahren ausgeführten, vom Taktgeber (8) gesteuerten Modulators (1) bestimmt.

d) Ein zweiter Kondensator (25) wird mit einer Referenzladung aufgeladen, während der Ausgang des Quantisierers (3) auf "0" ist, und an den Eingang des Integrators (17, 18) gelegt, solange der Ausgang des Quantisierers (3) auf "1" ist.

e) Dem ersten Komparator (26) ist ein vom Taktgeber (8) gesteuertes Flip-Flop (27) nachgeschaltet, dessen Ausgang den Ausgang des Quantisierers (3) darstellt.

2. Elektronischer Elektrizitätszähler nach Anspruch 1, dadurch gekennzeichnet, daß der nach dem Delta-Sigma-Verfahren arbeitende Modulator (1), folgende Merkmale aufweist:

a) Während jeder ersten Taktphase des Taktgebers (8) wird ein dritter Kondensator (11) auf eine der ersten Eingangsgröße (U) proportionale Spannung und ein vierter Kondensator (30) mit einer Referenzladung aufgeladen, deren Polarität von dem Ausgangssignal des Modulators (1) abhängig ist.

b) Während jeder zweiten Taktphase werden der dritte und der vierte Kondensator (11, 30) parallel zueinander mit dem Eingang eines weiteren Integrators (4, 5) verbunden, der aus einem ersten Operationsverstärker (4) mit einem fünften Kondensator (5) im Rückkopplungszweig besteht.

c) Der Ausgang des weiteren Integrators (4,5) ist mit einem zweiten Komparator (6) verbunden, dem ein taktgesteuertes Speicherglied (7) nachgeschaltet ist, dessen Takteingang von dem Taktgeber (8) angesteuert wird.

d) Der Ausgang des taktgesteuerten Speichergliedes (7) stellt den Ausgang des Modulators (1) dar.

3. Elektronischer Elektrizitätszähler nach Anspruch 1 oder 2, dadurch gekennzeichnet, daß während der ersten Taktphase des Taktgebers (8) eine der zweiten Eingangsgröße (I) proportionale Spannung über einen zweiten Operationsverstärker (13) in Spannungsfolgerschaltung einen sechsten Kondensator (14) auflädt, der während der zweiten Taktphase den ersten Kondensator (23) auflädt.

4. Elektronischer Elektrizitätszähler nach Anspruch 3, dadurch gekennzeichnet, daß eine Verstärkung der zweiten Eingangsgröße (I) dadurch erzielt wird, daß der über den zweiten Operationsverstärker (13) aufgeladene sechste Kondensator (14) eine größere Kapazität hat als der erste Kondensator (23).

5. Elektronischer Elektrizitätszähler nach einem der Ansprüche 1 bis 4, dadurch gekennzeichnet, daß alle Referenzladungen aus einer Referenzspannungsquelle ($U_{ref}$) bezogen werden.

## Claims

1. Electronic electricity meter having a multiplier (1, 2), operating according to the timedivision method, for first and second input quantities (U, I), the first input quantity (U) being supplied to a modulator (1), representing a component part of the multiplier (1, 2), and having a quantizer (3), subsequently connected to the multiplier (1, 2), the quantizer (3) operating according to the charge compensation method and being constructed with an integrator (17, 18) and a subsequently connected first comparator (26), characterized in that the multiplier (1, 2) and the quantizer (3) have the following features:
a) During each first time phase of a clock generator (8) a first capacitor (23) is connected to the input of the integrator (17, 18).
b) During each second time phase of the clock generator (8) the first capacitor (23) is charged with a charge proportional to the second input quantity (I).
c) The polarity with which the first capacitor (23) is placed at the input of the integrator (17, 18) is determined by the output signal of the modulator (1), constructed according to the delta-sigma method and controlled by the clock generator (8).
d) A second capacitor (25) is charged with a reference charge, while the output of the quantizer (3) is at «0», and is placed at the input of the integrator (17, 18), as long as the output of the quantizer (3) is at «1».
e) A flip-flop (27), controlled by the clock generator (8), is subsequently connected to the first comparator (26), the output of the flip-flop (27) representing the output of the quantizer (3).

2. Electronic electricity meter according to claim, characterized in that the modulator (1), operating according to the delta-sigma method, has the following features:
a) During each first time phase of the clock generator (8) a third capacitor (11) is charged to a voltage, proportional to the first input quantity (U), and a fourth capacitor (30) with a reference charge, the polarity of which is dependent on the output signal of the modulator (1).
b) During each second time phase the third and the fourth capacitors (11, 30) are connected in parallel with one another to the input of a further integrator (4, 5), which consists of a first operational amplifier (4) with a fifth capacitor (5) in the feedback path.
c) The output of the further integrator (4, 5) is connected to a second comparator (6) to which a timecontrolled storage element (7) is subsequently connected, the time input of which is controlled by the clock generator (8).
d) The output of the time-controlled storage element (7) represents the output of the modulator (1).

3. Electronic electricity meter according to claim 1 or 2, characterized in that during the first time phase of the clock generator (8) a voltage, proportional to the second input quantity (I), charges by means of a second operational amplifier (13) in voltage follower circuit a sixth capacitor (14), which charges the first capacitor (23) during the second time phase.

4. Electronic electricity meter according to claim 3, characterized in that an amplification of the second input quantity (I) is achieved in that the sixth capacitor (14), charged by means of the second operational amplifier (13), has a greater capacitance than the first capacitor (23).

5. Electronic electricity meter according to one of claims 1 to 4, characterized in that all reference charges are obtained from a reference voltage source (U_ref).

## Revendications

1. Compteur d'électricité électronique comportant un premier multiplicateur opérant suivant le procédé à partage de temps (1, 2) pour une première et une seconde grandeurs d'entrée (U, I) la première grandeur d'entrée (U) étant appliquée à un modulateur (1) qui représente une partie constitutive du multiplicateur (1, 2), et avec un quantificateur (3), monté en aval du multiplicateur (1, 2) et qui opère selon le procédé de compensation de charges et qui est réalisé avec un intégrateur (17, 18) et un premier comparateur aval (26), caractérisé par le fait que le multiplicateur (1, 2) et le quantificateur (3) comportent les particularités suivantes :
a) pendant chaque première phase de cadence d'un générateur de cadence (8), un premier condensateur (23) est relié à l'entrée de l'intégrateur (17, 18),
b) pendant chaque seconde de phase de cadence du générateur de cadence (8), le premier condensateur (23) est chargé avec une charge qui est proportionnelle à la seconde grandeur d'entrée (I),
c) la polarité avec laquelle le premier condensateur (23) est relié à l'entrée de l'intégrateur (17), est déterminée par le signal de sortie du modulateur (1) qui est réalisé suivant le procédé Delta-Sigma et commandé par le générateur de cadence (8),
d) un second condensateur (25) est chargé avec une charge de référence, alors que la sortie du quantificateur (3) est à «0» et il est relié à l'entrée de l'intégrateur (17, 18) tant que la sortie du quantificateur (3) est à «1»,
e) en aval du premier comparateur (26) est monté un multivibrateur bistable (27), commandé par le générateur de cadence (8) et dont la sortie représente la sortie du quantificateur (3).

2. Compteur électrique électronique selon la revendication 1, caractérisé par le fait que le modulateur (1) qui opère selon le procédé Delta-Sigma, comporte les particularités suivantes:
a) pendant chaque première phase de cadence du générateur de cadence (8), un troisième condensateur (11) est chargé à une tension qui est proportionnelle à la première grandeur d'entrée (U), et un quatrième condensateur (30) est chargé avec une charge de référence, dont la polarité dépend du signal de sortie du modulateur (1),
b) pendant chaque seconde de phase de cadence, le troisième et le quatrième condensateurs (11, 30) sont reliés, en parallèle entre eux, à l'entrée d'un second intégrateur (4, 5) qui est constitué par un premier amplificateur opérationnel (4) avec un cinquième condensateur (5) dans la branche de rétroaction,

c) la sortié dudit second intégrateur (4, 5) est reliée à un second comparateur (6) à la suite duquel est monté un élément de mémoire (7), commandé par la cadence, et dont l'entrée de cadence est attaquée par le générateur de cadence (8),

d) la sortie de l'élément de mémoire (7), commandée en cadence, représente la sortie du modulateur (1).

3. Compteur d'électricité électronique selon la revendication 1 ou 2, caractérisé par le fait que pendant la première phase de cadence du générateur de cadence (8), une tension qui est proportionnelle à la seconde grandeur d'entrée (I) charge, par l'intermédiaire d'un second amplificateur opérationnel (13) en circuit à couplage en tension, un sixième condensateur (14) qui, pendant la seconde phase de cadence, charge le premier condensateur (23).

4. Compteur d'électricité électronique selon la revendication 3, caractérisé par le fait qu'une amplification de la seconde grandeur d'entrée (I) est obtenue en faisant en sorte que le sixième condensateur (14) qui est chargé par l'intermédiaire du seconde amplificateur opérationnel (13), possède une capacité qui est plus grande que celle du premier condensateur (23).

5. Compteur d'électricité électronique selon l'une des revendications 1 à 4, caractérisé par le fait que toutes les charges de référence sont obtenues à partir d'une source de tension de référence ($u_{ref}$).

EP 0 232 763 B1